# EUROPÄISCHE PATENTANMELDUNG

(11) **EP 3 584 566 A1**
(43) Veröffentlichungstag der Anmeldung: **25.12.2019**
(21) Anmeldenummer: 19178070.9
(22) Anmeldetag: 04.06.2019
(51) Int. Cl.: G01N 21/65

(54) **MESSVORRICHTUNG UND VERFAHREN ZUR ZEITAUFGELÖSTEN MESSUNG EINES MESSSIGNALS**

(30) Priorität: 19.06.2018 DE 102018114697
(71) Anmelder: Krohne Messtechnik GmbH, 47058 Duisburg (DE)
(72) Erfinder: Tebrügge, Jan, 44227 Dortmund (DE); Förster, Jan, 45149 Essen (DE); Fritsch, Thomas, 41466 Neuss (DE)
(74) Vertreter: Gesthuysen Patent- und Rechtsanwälte

(57) **Zusammenfassung**

Beschrieben und dargestellt ist eine Messvorrichtung (1) zur zeitaufgelösten Messung eines Messsignals (3) und zur zeitlichen Separation wenigstens eines ersten Anteils (4) des Messsignals (3), mit einer Lichtquelle (5) zur Aussendung eines pulsförmigen Anregungssignals (6), mit wenigstens einem Detektor (9) für den Empfang des Messsignals (3), wobei der Detektor (9) aus dem Messsignal (3) ein Detektorsignal (11) erzeugt, mit wenigstens einer ersten Umformeinheit (12a) zur Erzeugung eines ersten Vergleichssignals (13), und mit wenigstens einer Auswerteeinheit (14). Die Messvorrichtung ist dadurch gekennzeichnet, dass das erste Vergleichssignal (13) mit dem Anregungssignal (6) korreliert, dass wenigstens eine erste Logikfunktion (15a) vorhanden ist, wobei die erste Logikfunktion (15a) im Betrieb zumindest das erste Vergleichssignal (13) und ein von dem Detektorsignal (11) abhängiges Signal (11, 18) derart miteinander verknüpft, dass die Ausgabe der Logikfunktion (15a) ein Maß für die Intensität des ersten Anteils (4) des Messsignals (3) bzw. des Detektorsignals (11) bereitstellt, wobei die Intensität eines Anteils des Messsignals durch die Anzahl an Photonen, die während der Zeitdauer des zu separierenden Anteils des Messsignals auf den Detektor treffen, gegeben ist und dass der Ausgang der ersten Logikfunktion (15a) mit der wenigstens einen Auswerteeinheit (14) verbunden ist

## Beschreibung

Die Erfindung geht aus von einer Messvorrichtung zur zeitaufgelösten Messung eines Messsignals und zur zeitlichen Separation wenigstens eines ersten Anteils des Messsignals, mit einer Lichtquelle zur Aussendung eines pulsförmigen Anregungssignals, mit wenigstens einem Detektor für den Empfang des Messsignals, wobei der Detektor aus dem Messsignal ein Detektorsignal erzeugt, mit wenigstens einer ersten Umformeinheit zur Erzeugung eines ersten Vergleichssignals und mit wenigstens einer Auswerteeinheit.

Das Anregungssignal zur Anregung der zu untersuchenden Probe ist im Rahmen der vorliegenden Erfindung ein elektromagnetisches Signal. Beispielsweise kann die Wellenlänge des Anregungssignals im sichtbaren Spektralbereich oder im UV- oder im IR-Bereich liegen. Besonders bevorzugt ist die Lichtquelle als Laser ausgestaltet.

Das Messsignal ergibt sich im Betrieb der Messvorrichtung durch die Wechselwirkung des Anregungssignals mit der zu untersuchenden Probe.

Darüber hinaus betrifft die Erfindung ein Verfahren zur zeitaufgelösten Messung eines Messsignals und zur zeitlichen Separation wenigstens eines ersten Anteils des Messsignals mit einer Messvorrichtung, wobei die Messvorrichtung eine Lichtquelle zur Aussendung eines pulsförmigen Anregungssignals aufweist, wobei die Messvorrichtung wenigstens einen Detektor für den Empfang des Messsignals aufweist, wobei der Detektor aus dem Messsignal ein Detektorsignal erzeugt, wobei die Messvorrichtung wenigstens eine Umformeinheit zur Erzeugung eines Vergleichssignals aufweist und wobei die Messvorrichtung wenigstens eine Auswerteeinheit aufweist.

Erfindungsgemäße Messvorrichtungen betreffen insbesondere Raman- oder Fluoreszenz-Spektrometer.

Zur spektroskopischen qualitativen und quantitativen Bestimmung von Stoffkonzentrationen in komplexen Gemischen ist insbesondere die Raman-Spektroskopie eine etablierte Technologie. Häufig - insbesondere in biologischen Medien (Fermentationen, Bierherstellung, Milch) oder in Anwesenheit von Farbstoffen (zum Beispiel in Softdrinks) - wird die Raman-Emission stark durch Fluoreszenz-Emission überlagert.

Neben der Analyse der Ramanstreuung kann auch die Fluoreszenzintensität einer Probe sowie deren zeitlicher Verlauf zur qualitativen und quantitativen Analyse beispielsweise von Stoffgemischen herangezogen werden.

Eine Technik, die Fluoreszenz-Emission und die Raman-Emission voneinander zu trennen, ist die Time-Gated Raman-Spektroskopie. Hierbei wird ausgenutzt, dass nach der Anregung einer Probe die Raman-Emission nahezu instantan auftritt, während die Fluoreszenz-Emission zeitversetzt ausgesendet wird. Durch verschiedene Maßnahmen kann erreicht werden, dass das Messsignal nur in einem kurzen Zeitfenster auf den Detektor treffen kann oder dass der Detektor nur während eines kurzen Zeitfensters eingeschaltet ist. Dieses Zeitfenster wird so gelegt, dass vorwiegend das Raman-Signal detektiert und das Fluoreszenz-Signal unterdrückt wird. Eine solche Beschaltung des Detektors ist technisch jedoch sehr aufwendig.

Aus der Druckschrift EP 2 761 276 B1 ist ein Mikroskop mit einer Auswerteschaltung zum Auswerten der elektrischen Signale eines optoelektrischen Detektors, insbesondere zur Aufnahme von Fluoreszenzereignissen sowie ein Verfahren zum Aufzeichnen von Fluoreszenzereignissen bekannt. Die Auswerteschaltung umfasst einen Analog-Digital-Wandler (A/D-Wandler), der mit dem Detektor verbunden ist. Die Auswerteschaltung umfasst weiterhin ein Schieberegister, wobei zu unterschiedlichen Zeitpunkten aufgenommene Lichtintensitäten in Form der mittels des Analog-Digital-Wandlers ausgegebenen Digitalwerte unabhängig voneinander in den Stufen des Schieberegisters gespeichert werden. Eine Verzögerungseinheit erzeugt Markierungswerte, die zeitlich den Fluoreszenzereignissen zuzuordnen sind und die ebenfalls in dem Schieberegister gespeichert werden. Durch die Verknüpfung der Markierungswerte und den aufgenommenen Messereignissen ist letztendlich eine zeitliche Unterscheidung von Raman- und Fluoreszenzereignissen möglich.

Aus der Druckschrift US 2001/0015411 A1 ist es bekannt, zur zeitlichen Separation von Messsignalen das Anregungssignal, im Detail einen Laserpuls, durch eine Umformeinheit zu formen und zeitlich zu verzögern und einen hinter dem Detektor angeordneten A/D-Wandler mit Hilfe dieses zeitverzögerten Signals derart zu beschalten, dass der A/D-Wandler lediglich das zu separierende Fluoreszenzsignal digitalisiert.

Zudem ist es aus den Dokumenten GB 723240 A und GB 1077501 A bekannt, die Signale von zeitlich nacheinander auftretenden Ereignissen durch eine logische Verknüpfung in verschiedene Kanäle zu separieren.

Ausgehend von dem zuvor dargelegten Stand der Technik ist es Aufgabe der Erfindung, eine Messvorrichtung zur zeitaufgelösten Messung eines Messsignals anzugeben, mit der eine zeitliche Separation wenigstens eines Anteils des Messsignals besonders einfach realisiert werden kann. Darüber hinaus ist es Aufgabe der Erfindung ein entsprechendes Verfahren zur zeitaufgelösten Messung eines Messsignals anzugeben.

Gemäß einer ersten Lehre der Erfindung wird die zuvor genannte Aufgabe durch eine eingangs beschriebene Messvorrichtung dadurch gelöst, dass das erste Vergleichssignal mit dem Anregungssignal korreliert, dass wenigstens eine erste Logikfunktion vorhanden ist, wobei die erste Logikfunktion im Betrieb zumindest das erste Vergleichssignal und ein von dem Detektorsignal abhängiges Signal derart miteinander verknüpft, dass die Ausgabe der Logikfunktion ein Maß für die Intensität des ersten Anteils des Messsignals bzw. des Detektorsignals bereitstellt, wobei die Intensität eines Anteils des Messsignals durch die Anzahl an Photonen, die während der Zeitdauer des zu separierenden Anteils des Messsignals auf den Detektor treffen, gegeben ist, und dass der Ausgang der ersten Logikfunktion mit der wenigstens einen Auswerteeinheit verbunden ist.

Erfindungsgemäß weist das Detektorsignal eine Folge von wenigstens zwei, vorzugsweise pulsartigen Anteilen auf. Diese pulsartigen Signalanteile werden durch die Absorption eines Photons im Detektor erzeugt. Beispielsweise entspricht der erste Signalanteil einem Ramansignal und ein zweiter Signalanteil einem Fluoreszenzsignal. Der erste zu separierende Anteil des Messsignals ist gemäß einer Ausgestaltung auch zeitlich gesehen der erste Signalanteil. Gemäß einer weiteren Ausgestaltung kann der erste zu separierende Anteil auch zeitlich nach einem weiteren Signalanteil auf den Detektor treffen.

Es wurde erkannt, dass wenigstens ein Anteil des Messsignals besonders einfach dadurch separiert werden kann, dass das von dem Detektorsignal abhängige Signal mit einem weiteren Signal (Vergleichssignal) synchronisiert und über eine Logikfunktion, die an eine Logikeinrichtung geknüpft ist, derart verknüpft wird, dass die Ausgabe der Logikfunktion ein Maß für die Intensität des zu separierenden Signalanteils bereitstellt. Eine aufwendige Beschaltung des Detektors kann auf diese Weise vorteilhaft vermieden werden.

Im Rahmen der vorliegenden Erfindung ist die Intensität eines Anteils des Messsignals durch die Anzahl an Photonen, die während der Zeitdauer des zu separierenden Anteils des Messsignals auf den Detektor treffen, gegeben. Da im Detektor jedes auftreffende Photon ein pulsförmiges Signal erzeugt, kann basierend auf der Ausgabe der Logikfunktion die Anzahl an pulsförmigen Signalen des ersten Anteils des Detektorsignals und insofern die Anzahl an Photonen, die während dieser Zeitdauer auf den Detektor treffen, bestimmt werden.

Die erfindungsgemäße Messvorrichtung eignet sich insbesondere zur Messung der Ramanaktivität einer Probe. Im Detail misst die Messvorrichtung im Betrieb die Anzahl an auf den Detektor treffenden Raman-Photonen innerhalb eines definierten Zeitfensters. Das definierte Zeitfenster deckt besonders bevorzugt den Zeitbereich ab, in dem ein oder mehrere Raman-Photonen und zeitlich später emittierte Fluoreszenzphotonen nicht gleichzeitig auf den Detektor treffen. Im Rahmen der vorliegenden Erfindung umfasst ein Messzyklus die Aussendung eines einzigen Anregungspulses sowie die Messung der Intensität des ersten Anteils des Messsignals. Wird diese Intensität, also die gemessene Anzahl an Photonen pro Messzyklus während einer Messzeit aufsummiert, wobei die Messzeit eine vorgebbare Anzahl an Messzyklen aufweist, und wird die Summe an gemessenen Photonen über mehrere Messzeiten gemittelt, lässt sich mittels der Auswerteeinheit eine Aussage über die Ramanaktivität der Probe treffen.

Bei der Bestimmung der Messzeit wird vorzugsweise davon ausgegangen, dass sich die Art und/oder die Eigenschaften der Probe während einer Messzeit bzw. während der Messzeiten, die zur Bestimmung der Ramanaktivität der Probe betrachtet werden, nicht ändert bzw. nicht ändern.

Bei der Messung der Ramanaktivität ist die Anzahl der unmittelbar von der Probe ausgesendeten Raman-Photonen insbesondere abhängig von der Energie des pulsförmigen Anregungssignals.

Gemäß einer bevorzugten Ausgestaltung ist das Anregungssignal bzw. das Vergleichssignal im Betrieb derart ausgestaltet, dass innerhalb eines Messzyklus erwartungsgemäß eine Intensität von 0 oder 1 gemessen wird. Gemäß dieser Ausgestaltung trifft in dem relevanten Zeitfenster typischerweise maximal ein Photon auf den Detektor.

Gemäß einer nächsten Ausgestaltung ist das Anregungssignal bzw. das Vergleichssignal im Betrieb derart ausgestaltet, dass innerhalb eines Messzyklus erwartungsgemäß eine Intensität größer 1 gemessen werden kann. Gemäß dieser Ausgestaltung können typischerweise in dem relevanten Zeitfenster mehr als ein Photon auf den Detektor treffen. Diese Ausgestaltung weist den Vorteil auf, dass die Messzeit verkürzt und die Genauigkeit der Messung erhöht werden kann.

Das von dem Detektorsignal abhängige Signal entspricht gemäß einer Ausgestaltung dem Detektorsignal. In einer anderen Ausgestaltung ist es von dem Detektorsignal abgeleitet beispielsweise mittels eines Zeitverzögerungselementes und/oder durch ein Mittel zur Formung, insbesondere zur zeitlichen Dehnung oder zur Stauchung, des Detektorsignals.

Der Detektor ist vorzugsweise derart ausgestaltet, dass er kontinuierlich das Messsignal detektiert und weiterleitet. Durch eine kontinuierliche Aufnahme des Messsignals kann nicht nur der zu separierende Anteil aus dem Detektorsignal herausgefiltert werden, es besteht darüber hinaus die Möglichkeit auch die übrigen Anteile des Messsignals bzw. des Detektorsignals herauszufiltern und auszuwerten, um aus diesen weitere Informationen zu gewinnen. Alternativ kann der Detektor ebenfalls derart ausgestaltet sein, dass er nur zeitweise aktiv ist.

Beispielsweise ist der Detektor als Multi-Pixel-Photon-Counter (MPPC) ausgestaltet. Gemäß einer nächsten Ausgestaltung ist der Detektor als Photomultiplier, als intensified charge-coupled device (ICCD) oder als Single Photon Avalanche Diode (SPAD) ausgestaltet.

Gemäß einer Ausgestaltung besteht die Korrelation zwischen dem ersten Vergleichssignal und dem Anregungssignal darin, dass das Vergleichssignal im Betrieb aus dem Anregungssignal abgeleitet ist. Vorzugsweise ist dann wenigstens ein zweiter Detektor vorhanden, der derart ausgestaltet und angeordnet ist, dass der zweite Detektor das von der Lichtquelle ausgesendete Anregungssignal unmittelbar, d.h. ohne vorherige Wechselwirkung mit der zu untersuchenden Probe, detektiert und an die Umformeinheit weiterleitet. Gemäß einer weiteren Ausgestaltung weist die Lichtquelle einen Trigger auf, wobei der Trigger mittels eines Triggersignals das pulsförmige Anregungssignal auslöst und wobei die Korrelation zwischen dem ersten Vergleichssignal und dem Anregungssignal darin besteht, dass das Vergleichssignal aus dem Triggersignal abgeleitet ist. Gemäß dieser Ausgestaltung wird das Triggersignal an die Umformeinheit weitergeleitet.

Gemäß einer besonders bevorzugten Ausgestaltung weist das Vergleichssignal wenigstens einen positiven Signalanteil auf, dessen Amplitude innerhalb eines Spannungsbereichs liegt, der von der Logikfunktion als 1 interpretiert wird.

Gemäß einer bevorzugten Ausgestaltung weist die Umformeinheit wenigstens eine, vorzugsweise programmierbare, Verzögerungseinheit auf, wobei die Verzögerungseinheit derart ausgestaltet ist, dass im Betrieb das pulsförmige Anregungssignal und/oder das Triggersignal durch die Verzögerungseinheit mit dem von dem Detektorsignal abhängigen Signal zeitlich synchronisiert wird. Hierzu wird das Anregungssignal und/oder das Triggersignal um ein Zeitintervall Δt verzögert.

Im Rahmen der vorliegenden Anmeldung wird unter einer Synchronisation des Vergleichssignals mit dem von dem Detektorsignal abhängigen Signal zum Beispiel verstanden, dass der positive Teil des Vergleichssignals und der erste Anteil des Detektorsignals zeitgleich an der Logikfunktion anliegen. Dazu wird das pulsförmige Anregungssignal und/oder das Triggersignal durch das Verzögerungselement um ein Zeitintervall Δt verschoben, wobei das Zeitintervall Δt dem zeitlichen Abstand zwischen dem pulsförmigen Anregungssignal oder dem Triggersignal und dem ersten Anteil des Messsignals entspricht. Dieser Zeitabstand Δt liegt beispielsweise im ps-Bereich.

Zudem meint eine Synchronisation des Vergleichssignals mit dem von dem Detektorsignal abhängigen Signal gemäß einer nächsten Ausgestaltung aber auch, dass ein fest definierter zeitlicher Abstand zwischen dem Anregungssignal oder dem Triggersignal und dem ersten Anteil des Detektorsignals vorhanden sein kann.

Beispielsweise kann der positive Teil des Vergleichssignals auch zeitgleich mit wenigstens einem zweiten Anteil des Detektorsignals an der Logikfunktion anliegen. Die Ausgestaltung der Synchronisation ist insbesondere abhängig von der Art der Logikverknüpfung.

Weist die Umformeinheit eine programmierbare Verzögerungseinheit, beispielsweise eine programmierbare Verzögerungsleitung auf, so wird die Verzögerungszeit Δt vorgegeben. Vorzugsweise basiert die Verzögerungszeit Δt gemäß dieser Ausgestaltung auf einer Abschätzung oder auf zuvor ermittelten Zeitdifferenzen.

Gemäß einer nächsten Ausgestaltung weist die Umformeinheit wenigstens ein Mittel zur Erzeugung wenigstens eines positiven Signals für eine Zeitdauer t₂ in einem zeitlichen Abstand von t₁ ≥ 0 von dem Anregungssignal oder dem Triggersignal auf. Besonders bevorzugt ist das positive Signal als einfaches Rechtecksignal ausgestaltet. Andere geeignete Signalformen sind ebenfalls denkbar.

Durch das wenigstens eine positive Signal mit der Zeitdauer t₂ wird ein Zeitfenster für die Separation des ersten Anteils des Detektorsignals erzeugt.

Vorzugsweise entspricht die Zeitdauer t₂ im Wesentlichen der Zeitdauer des ersten Anteils des Detektorsignals oder der Zeitdauer eines zweiten Anteils des Detektorsignals.

Gemäß einer besonders bevorzugten Ausgestaltung entspricht die Zeitdauer t₂ im Wesentlichen der Dauer des pulsförmigen Anregungssignals. Hierdurch kann bei der Messung der Ramanaktivität einer Probe gewährleistet werden, dass nur Raman-Photonen und keine Fluoreszenz-Photonen gemessen werden, sofern die Zeitdauer t₂ hinreichend kurz bemessen ist.

Wird das positive Signal in einem Zeitabstand t₁ = 0 erzeugt, so entspricht dieser Vorgang einer Verformung des ursprünglichen Anregungssignals oder des ursprünglichen Triggersignals. Wird das positive Signal in einem Zeitabstand t₁ > 0 erzeugt, so entspricht t₁ vorzugsweise dem zeitlichen Abstand zwischen dem Anregungssignal oder dem Triggersignal und dem ersten Signalanteil des Detektorsignals.

Gemäß einer weiteren Ausgestaltung werden in der Umformeinheit mehrere, zeitlich aufeinanderfolgende, positive Signalanteile erzeugt. Die einzelnen Signalanteile können dabei die gleiche Zeitdauer t₂ aufweisen, sie können aber auch eine unterschiedliche Zeitdauer aufweisen. Liegt diese Abfolge von positiven Signalanteilen beispielsweise zeitgleich mit dem zu separierenden ersten Signalanteil an der Logikfunktion an und ist die Logikfunktion beispielsweise als AND-Verknüpfung ausgestaltet, kann weiterhin der zeitliche Intensitätsverlauf des ersten Anteils des Detektorsignals ausgewertet werden.

Gemäß einer weiteren bevorzugten Ausgestaltung weist die Umformeinheit wenigstens ein Mittel zur zeitlichen Dehnung und/oder zur zeitlichen Stauchung des Anregungssignals oder des Triggersignals auf.

Gemäß einer nächsten Ausgestaltung ist wenigstens eine weitere Umformeinheit vorhanden, wobei die weitere Umformeinheit mit dem Ausgang des Detektors verbunden ist, wobei die weitere Umformeinheit vorzugsweise eine Verzögerungseinheit aufweist, wobei die Verzögerungseinheit das Detektorsignal mit dem Vergleichssignal synchronisiert. Hierzu wird das Detektorsignal um ein Zeitintervall Δt verzögert.

Gemäß einer Ausgestaltung wird das Detektorsignal derart verzögert, dass der erste Anteil des Detektorsignals zeitlich mit dem nächsten nachfolgenden Anregungssignal oder Triggersignal übereinstimmt.

Gemäß einer Ausgestaltung sind zwei Verzögerungseinheiten vorhanden, wobei die Verzögerungseinheiten vorzugsweise als programmierbare Verzögerungsleitungen ausgestaltet sind. Gemäß dieser Ausgestaltung weist die Umformeinheit zur Erzeugung des Vergleichssignals eine Verzögerungseinheit auf und weiterhin weist die weitere Umformeinheit zwischen dem Detektorausgang und der Logikfunktion eine Verzögerungseinheit auf. Durch das Vorhandensein von zwei Verzögerungseinheiten lässt sich die Synchronisation der Signale besonders genau einstellen.

Gemäß einer weiteren Ausgestaltung ist eine zweikanalige Verzögerungsleitung vorhanden, wobei an einen ersten Eingang das Triggersignal bzw. das Anregungssignal übermittelt wird und wobei an einem zweiten Eingang das Detektorsignal übermittel wird. Gemäß dieser Ausgestaltung sind die beiden Umformeinheiten zu einer Einrichtung zusammengefasst.

Gemäß einer weiteren Ausgestaltung umfasst die Logikfunktion wenigstens eine AND-Verknüpfung, eine OR-Verknüpfung, eine XOR-Verknüpfung, eine NAND-Verknüpfung, eine NOR-Verknüpfung oder eine XNOR-Verknüpfung.

Sind das erste Vergleichssignal und das von dem Detektorsignal abhängige Signal mittels einer AND-Verknüpfung verknüpft, so ist das Vergleichssignal vorzugsweise mit dem ersten Anteil des Messsignals derart synchronisiert, dass der wenigstens eine positive Anteil des Vergleichssignals zeitgleich mit dem ersten Anteil des Detektorsignals an der logischen AND-Verknüpfung anliegt.

Gemäß einer nächsten Ausgestaltung können auch wenigstens zwei gleiche und/oder unterschiedliche Logikverknüpfungen in der wenigstens einen Logikfunktion realisiert sein.

Gemäß einer nächsten Ausgestaltung ist zur Bestimmung des Zeitversatzes Δt, insbesondere zwischen dem Anregungssignal bzw. dem Triggersignal und dem ersten Anteil des Detektorsignals, ein Time-to-Digital-Converter (TDC) vorhanden. In vorteilhafter Weise kann der Zeitversatz Δt empirisch bestimmt werden, wodurch mit Ungenauigkeiten behaftete Schätzungen vermieden werden können.

Gemäß einer Ausgestaltung misst der TDC im Betrieb den Zeitversatz zwischen dem Anregungssignal bzw. dem Triggersignal und einem zweiten Anteil des Detektorsignals.

Gemäß einer nächsten Ausgestaltung ist die wenigstens eine Logikfunktion und/oder die wenigstens eine Umformeinheit in einem Mikrokontroller implementiert.

Weiterhin ist es vorteilhaft, wenn die wenigstens eine Logikfunktion als Logikgatter ausgestaltet ist.

Gemäß einer weiteren Ausgestaltung ist die Logikfunktion in einem Multiplexer realisiert.

Gemäß einer nächsten Ausgestaltung der Messvorrichtung umfasst die Auswerteeinheit wenigstens einen Zähler. Gemäß einer nächsten Ausgestaltung sind wenigstens zwei Zähler vorhanden. Im Betrieb zählt der Zähler die Anzahl der Photonen, die innerhalb des relevanten Zeitraums, der durch die Synchronisation des Vergleichssignals und des von dem Detektorsignal abhängigen Signal definiert wird, auf den Detektor treffen.

Vorzugsweise ist die Auswerteeinheit derart ausgestaltet, dass der wenigstens eine Zähler die Anzahl der Photonen, die innerhalb einer Messzeit, also im Laufe von aufeinanderfolgenden Messzyklen auf den Detektor treffen, aufsummiert. Besonders bevorzugt ist die Auswerteeinheit weiterhin derart ausgestaltet, dass sie zur Bestimmung der Ramanaktivität einer Probe eine statistische Analyse über die Anzahl Raman-Photonen, die während verschiedener aufeinanderfolgender Messzeiten gemessen wurden, durchführt.

Gemäß einer weiteren Ausgestaltung ist die Auswerteeinheit derart ausgestaltet, dass zur Ermittlung der Anzahl an auf den Detektor treffenden Photonen weitere Parameter des pulsförmigen Detektorsignals ausgewertet werden. Entsprechende Parameter sind insbesondere die Pulshöhe und/oder die Pulsfläche und/oder die Pulsform. Gemäß dieser Ausgestaltung ist die Logikfunktion vorzugsweise in einem Multiplexer realisiert, sodass an die Auswerteeinheit das pulsförmige Detektorsignal bzw. der zu extrahierende pulsförmige Teil des Detektorsignals übermittelt wird.

Gemäß einer nächsten Ausgestaltung ist wenigstens eine weitere Umformeinheit zur Erzeugung eines zweiten Vergleichssignals vorhanden, wobei das zweite Vergleichssignal mit dem Anregungssignal korreliert, wobei wenigstens eine zweite Logikfunktion vorhanden ist, wobei die zweite Logikfunktion das zweite Vergleichssignal und ein von dem Detektorsignal abhängiges Signal derart miteinander verknüpft, dass die Ausgabe der Logikfunktion ein Maß für die Intensität eines zweiten Anteils des Messsignals bereitstellt und dass der Ausgang der zweiten Logikfunktion mit der wenigstens einen Auswerteeinheit verbunden ist. Gemäß dieser Ausgestaltung kann neben einem ersten Anteil des Messsignals ebenfalls ein zweiter Anteil des Messsignals separiert werden, wodurch mehr Informationen über die zu vermessende Probe bereitgestellt werden.

Gemäß einer zweiten Lehre der vorliegenden Erfindung wird die eingangs hergeleitete Aufgabe durch ein eingangs beschriebenes Verfahren dadurch gelöst, dass das erste Vergleichssignal mit dem Anregungssignal korreliert, dass wenigstens eine erste Logikfunktion vorhanden ist, wobei die erste Logikfunktion das erste Vergleichssignal und ein von dem Detektorsignal abhängiges Signal miteinander verknüpft und dass der Ausgang der ersten Logikfunktion mit der wenigstens einen Auswerteeinheit verbunden ist, wobei das Verfahren in einem Messzyklus die folgenden Schritte aufweist:
- Aussenden eines pulsförmigen Anregungssignals durch die Lichtquelle,
- Wechselwirkung des Anregungssignals mit der Probe,
- Detektion und Umwandlung des Messsignals in ein Detektorsignal durch den Detektor,
- Erzeugen des Vergleichssignals in der Umformeinheit,
- Verknüpfen des Vergleichssignals und einem von dem Detektorsignal abhängigen Signal in der Logikfunktion zur Separation des ersten Anteils des Messsignals und
- Weiterleitung und Auswertung der Ausgabe der Logikfunktion durch die Auswerteeinheit, wobei die Auswertung die Bestimmung der Anzahl an Photonen, die während der Zeitdauer des zu separierenden Anteils des Messsignals auf den Detektor treffen, umfasst.

Dabei entspricht die Ausgabe der Logikfunktion einem Maß für die Intensität des ersten Anteils des Messsignals.

Gemäß einer bevorzugten Ausgestaltung umfasst das Verfahren mehrere Messzyklen, die innerhalb einer Messzeit durchlaufen werden, wobei die Auswerteeinheit die pro Messzyklus gemessenen Intensitäten zu einer Gesamtanzahl an Photonen, die während der Messzeit auf den Detektor treffen, aufsummiert.

Vorzugsweise umfasst das Verfahren zur Bestimmung der Ramanaktivität weiterhin mehrere Messzeiten, wobei gemäß einer Ausgestaltung durch die Auswerteeinheit eine statistische Analyse über die pro Messzeit gemessenen Gesamtanzahlen durchgeführt wird, wobei insbesondere der Mittelwert über die pro Messzeit gemessenen Gesamtanzahlen bestimmt wird.

Besonders bevorzugt weist das erfindungsgemäße Verfahren eine der zuvor dargelegten Messvorrichtungen auf. Bezüglich der einzelnen Ausgestaltungen des Verfahrens sowie deren Vorteile wird auf die Beschreibung der entsprechenden Ausgestaltungen der Messvorrichtung Bezug genommen.

Im Einzelnen gibt es nun eine Vielzahl von Möglichkeiten, die erfindungsgemäße Messvorrichtung und das erfindungsgemäße Verfahren auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung. In der Zeichnung zeigen
- Fig. 1: ein erstes Ausführungsbeispiel einer erfindungsgemäßen Messvorrichtung,
- Fig. 2: ein zweites Ausführungsbeispiel einer erfindungsgemäßen Messvorrichtung,
- Fig. 3: ein drittes Ausführungsbeispiel einer erfindungsgemäßen Messvorrichtung,
- Fig. 4: ein viertes Ausführungsbeispiel einer erfindungsgemäßen Messvorrichtung,
- Fig. 5: ein fünftes Ausführungsbeispiel einer erfindungsgemäßen Messvorrichtung,
- Fig. 6: in schematischer Darstellung den zeitlichen Verlauf des Anregungssignals, des Vergleichssignals und verschiedener Detektorsignale,
- Fig. 7: ein zweites Beispiel für den zeitlichen Verlauf des Vergleichssignals und des Detektorsignals
- Fig. 8: ein drittes Beispiel für den zeitlichen Verlauf des Vergleichssignals und des Detektorsignals,
- Fig. 9: ein viertes Beispiel für den zeitlichen Verlauf des Vergleichssignals und des Detektorsignals,
- Fig. 10: ein sechstes Beispiel einer erfindungsgemäßen Messvorrichtung,
- Fig. 11: in schematischer Darstellung den zeitlichen Verlauf des Vergleichssignals und des Detektorsignals des in Fig. 10 dargestellten Ausführungsbeispiels und
- Fig. 12: ein erstes Ausführungsbeispiel eines erfindungsgemäßen Verfahrens.

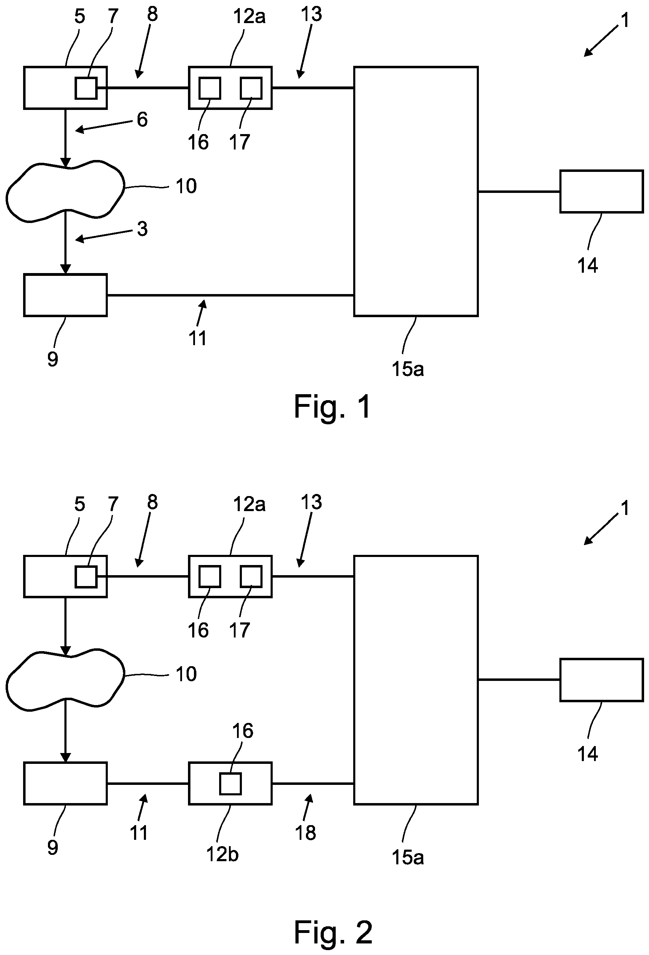

In Fig. 1 ist dargestellt eine Messvorrichtung 1 zur zeitaufgelösten Messung eines Messsignals 3 und zur zeitlichen Separation wenigstens eines ersten Anteils 4 des Messsignals 3, mit einer Lichtquelle 5 zur Aussendung eines pulsförmigen Anregungssignals 6, wobei die Lichtquelle 5 einen Trigger 7 aufweist, der mittels eines Triggersignals 8 das pulsförmige Anregungssignal 6 auslöst, mit wenigstens einem Detektor 9 für den Empfang des Messsignals 3, wobei das Messsignal 3 durch Wechselwirkung mit der nachzuweisenden Probe 10 entsteht, wobei der Detektor 9 zeitlich kontinuierlich arbeitet und wobei der Detektor 9 aus dem Messsignal 3 ein Detektorsignal 11 erzeugt. Im Detail ist die Messvorrichtung 1 zur Bestimmung der Ramanaktivität einer Probe 10 ausgestaltet.

Zudem weist die Messvorrichtung 1 eine Umformeinheit 12a zur Erzeugung eines ersten Vergleichssignals 13 und eine Auswerteeinheit 14 auf. Das erste Vergleichssignal 13 ist derart ausgestaltet, dass es mit dem Anregungssignal 6 korreliert. Im Detail ist das Vergleichssignal 13 aus dem Triggersignal 8 abgeleitet. Die Umformeinheit 12a ist derart ausgestaltet, dass sie das Triggersignal 8 zeitlich verzögert und weiterhin das Triggersignal 8 derart formt, dass es für eine Zeitdauer t₂ als positives Signal ausgestaltet ist. Im Ergebnis ist das Vergleichssignal 13 derart ausgestaltet, dass der positive Anteil des Vergleichssignals 13 mit dem zu separierenden ersten Anteil 4 des Detektorsignals 11 synchronisiert ist. Zudem ist eine Logikfunktion 15a in Form eines AND-Gatters vorhanden, wobei die Logikfunktion 15a das Vergleichssignal 13 und das Detektorsignal 11 miteinander verknüpft. Aufgrund der Synchronisation des positiven Anteils des Vergleichssignals 13 mit dem zu separierenden ersten Anteils 4 des Detektorsignals 11 wird ein Signal an die Auswerteeinheit 14 weitergeleitet, das ein Maß für die Intensität des ersten Anteils 4 des Detektorsignals 11 bereitstellt. Im dargestellten Ausführungsbeispiel weist die Auswerteeinheit 14 einen Zähler auf, der ein Maß für die Intensität des ersten Anteils 4 des Messsignals, im Detail die Anzahl der auf den Detektor treffenden Raman-Photonen während einer Messzeit mit einer Mehrzahl von Messzyklen aufsummiert. In vorteilhafter Weise kann der erste Anteil 4 des Detektorsignals 11 bzw. des Messsignals 3 mittels der dargestellten Messvorrichtung besonders einfach separiert und ausgewertet werden. Im Detail ist es also möglich lediglich die Aussendung von Raman-Photonen zu bestimmen, wobei eine Überlagerung mit Fluoreszenz-Photonen vermieden werden kann.

In dem in Fig. 2 dargestellten Ausführungsbeispiel der Messvorrichtung 1 ist zusätzlich eine zweite Umformeinheit 12b vorhanden, die mit dem Detektor 9 verbunden ist, wobei die zweite Umformeinheit 12b ebenfalls ein Verzögerungselement 16 aufweist, wobei das Verzögerungselement 16 das Detektorsignal 11 zeitlich derart verzögert, dass es mit dem geformten Triggersignal 8 zeitlich korreliert. Eine zeitliche Synchronisation des Vergleichssignals 13 und dem aus dem Detektorsignal 11 abgeleiteten Signal 18 kann gemäß dieser Ausführung besonders genau eingestellt werden.

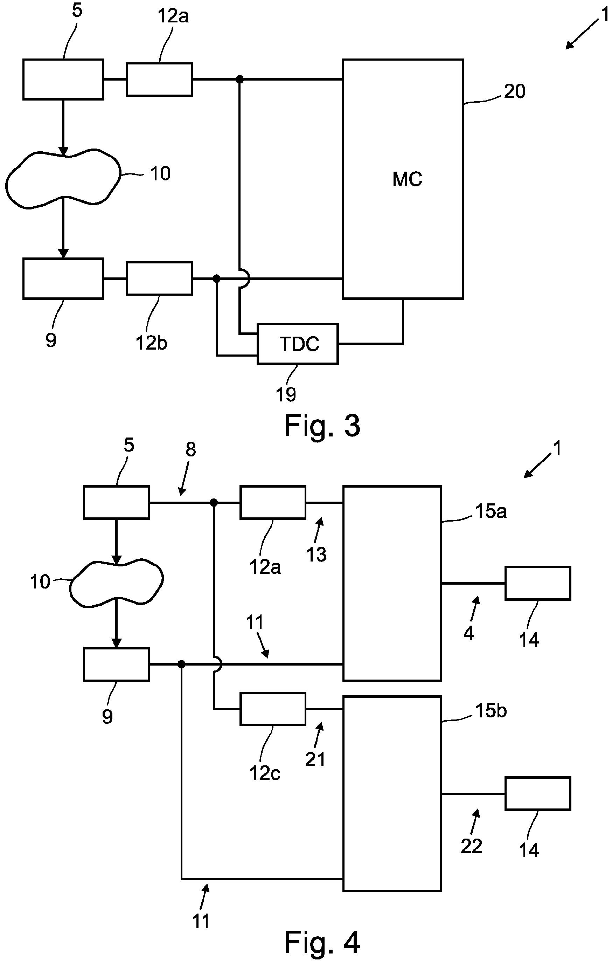

In dem in Fig. 3 dargestellten dritten Ausführungsbeispiel sind die Logikfunktion 15a und die Umformeinheit 12a in einem Mikrokontroller 20 implementiert. Zur Bestimmung des Zeitversatzes zwischen dem Triggersignal 8 und dem ersten Teil 4 des Detektorsignals 11 ist ein Time-to-Digital-Converter (TDC) 19 vorhanden.

In dem in Fig. 4 dargestellten Ausführungsbeispiel wird das Triggersignal 8 in einer ersten Umformeinheit 12a zu einem ersten Vergleichssignal 13 geformt, wobei das erste Vergleichssignal 13 mit dem ersten Anteil 4 des Detektorsignals 11 synchronisiert ist, sodass die als AND-Verknüpfung ausgestaltete erste Logikfunktion 15a ein Maß für die Intensität des ersten Signalanteils 4 des Detektorsignals 11 an die Auswerteeinheit 14 weiterleitet.

Gleichzeitig wird das Triggersignal 8 in einer zweiten Umformeinheit 12c zu einem zweiten Vergleichssignal 21 umgeformt, wobei das zweite Vergleichssignal 21 mit einem zweiten Anteil 22 des Detektorsignals 11 bzw. des Messsignals 3 synchronisiert ist, sodass die zweite Logikfunktion 15b, die hier ebenfalls als AND-Verknüpfung ausgestaltet ist, ein Maß für die Intensität des zweiten Signalanteils 22 des Detektorsignals 11 an die Auswerteeinheit 14 weiterleitet. Gemäß diesem Ausführungsbeispiel können in vorteilhafter Weise mehrere Signalanteile eines Messsignals 3 bzw. eines Detektorsignals 11 voneinander separiert und insofern gesondert ausgewertet werden.

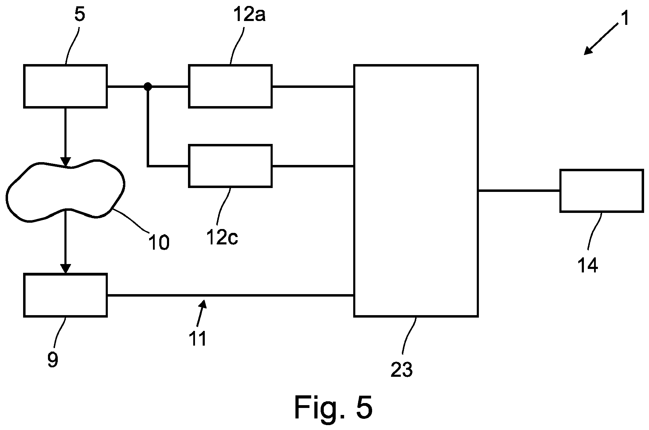

Grundsätzlich können die verschiedenen Logikfunktionen 15a, 15b durch separate Transistorschaltungen realisiert sein, alternativ dazu können diese Funktionen ebenfalls, wie in Fig. 5 dargestellt, durch einen integrierten Schaltkreis 23 realisiert sein.

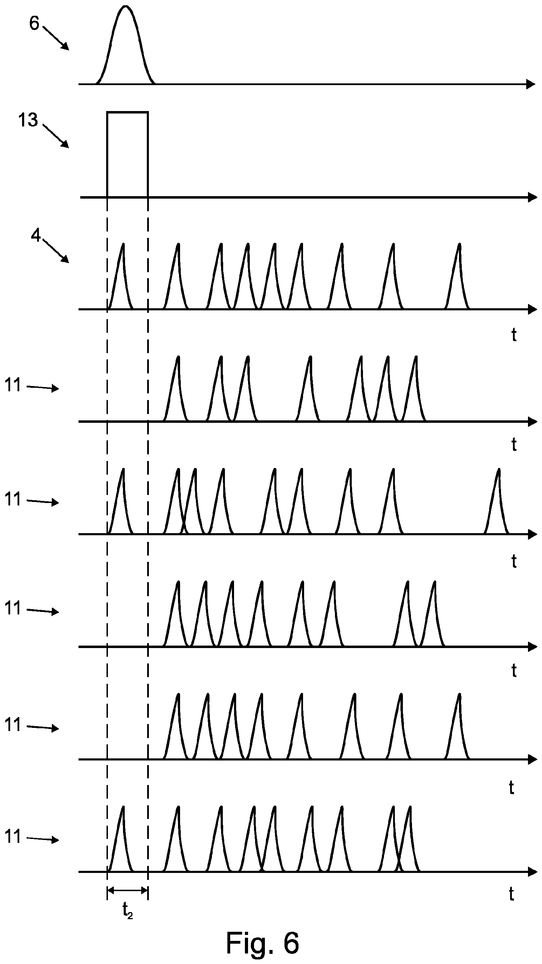

In Fig. 6 ist der Signalverlauf des Anregungssignals 6, des Vergleichssignals 13 und sechs aufeinanderfolgender Detektorsignale 11 dargestellt, wobei das Vergleichssignal 13 derart ausgestaltet und angepasst ist, dass der positive Anteil des Vergleichssignals 13 11 mit dem zu separierenden ersten Anteil 4 des Detektorsignals 11 synchronisiert ist. In den Fällen 1, 3 und 6 wird jeweils ein Raman-Photon detektiert, bei den übrigen Detektorsignalen 2, 4 und 5 wird in dem betrachteten Zeitraum kein Raman-Photon detektiert. Im dargestellten Ausführungsbeispiel entspricht die Dauer t₂ des Vergleichssignals 13 im Wesentlichen der zeitlichen Dauer des Anregungssignals 6, wodurch sichergestellt werden kann, dass lediglich Raman-Photonen und keine Fluoreszenz-Photonen detektiert werden, sofern die Zeitdauer t₂ hinreichend kurz bemessen ist.

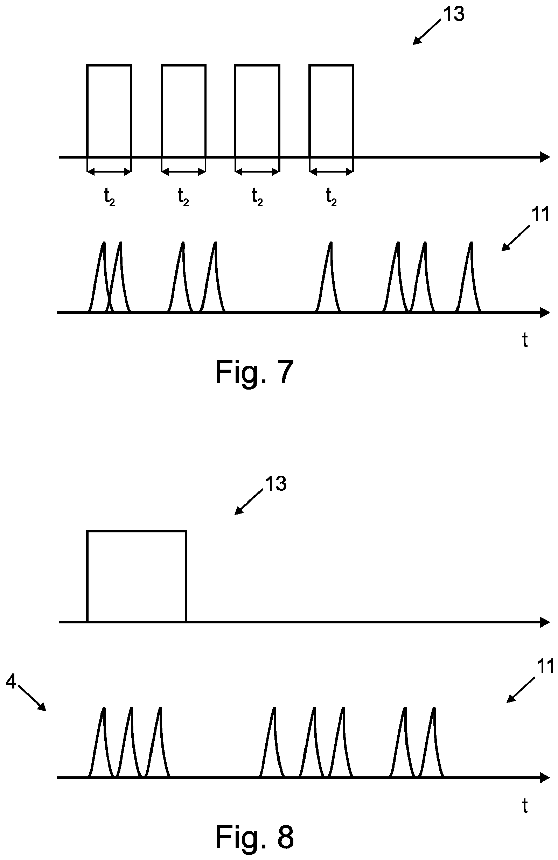

In Fig. 7 weist das Vergleichssignal 13 eine Folge von positiven Signalanteilen auf, wobei die Folge von positiven Signalanteilen insgesamt mit dem zu separierenden ersten Anteil 4 des Detektorsignals 11 synchronisiert ist. Wird das Detektorsignal 11 beispielsweise mittels einer Verknüpfung dieser Signale durch ein AND-Gatter abgetastet, und wird in der Auswerteeinheit die Anzahl an gemessenen Photonen für jeden positiven Anteil des Vergleichssignals 13 gesondert ausgewertet, kann eine Aussage über den Intensitätsverlauf des ersten Anteils 4 des Detektorsignals getroffen werden.

In dem in Fig. 8 dargestellten Ausführungsbeispiel ist das Anregungssignal 6 derart ausgestaltet, dass unmittelbar eine Mehrzahl an Raman-Photonen ausgesendet wird, sodass der zu separierende Anteil 4 des Messsignals 3 eine Mehrzahl Raman-Photonen aufweist, wobei die Zeitdauer t₂ des positiven Anteils des Vergleichssignals 13 der Zeitdauer der nachzuweisenden Raman-Photonen entspricht.

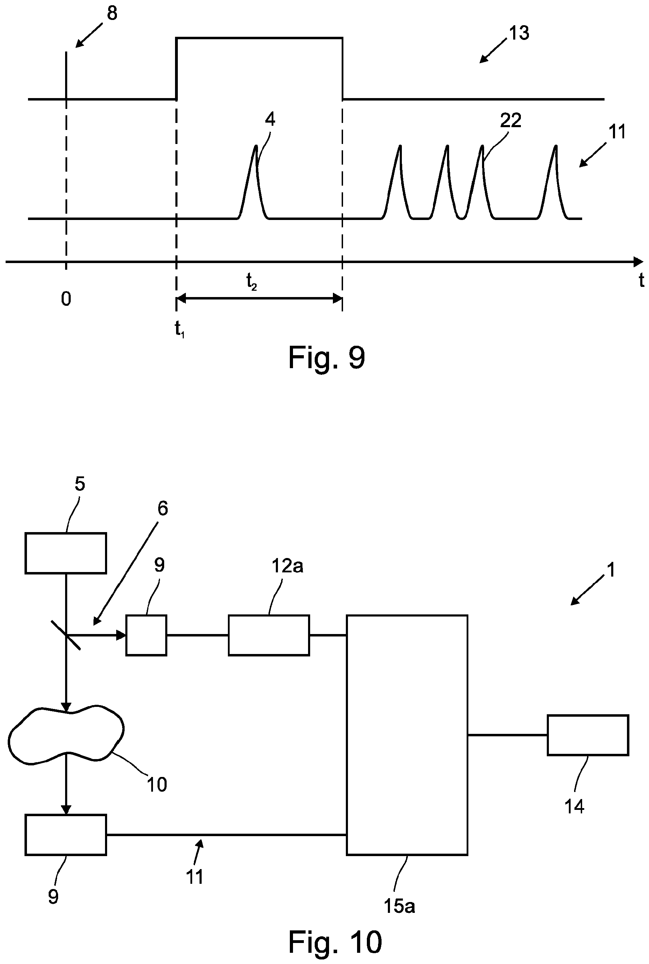

Im Unterschied dazu ist das Vergleichssignal 13 in Fig. 9 derart ausgestaltet, dass nach dem Triggersignal 8 in einem Zeitabstand t₁ ein positives Signal für eine Zeitdauer t₂ realisiert ist, wobei t₂ im Wesentlichen der Zeitdauer des zu separierenden Signalanteils 4 des Detektorsignals 11 entspricht.

In Fig. 10 ist ein nächstes Ausführungsbeispiel einer Messvorrichtung 1 dargestellt, wobei im Unterschied zu den zuvor beschriebenen Ausführungsbeispielen ein zweiter Detektor 9 vorhanden ist, der das Anregungssignal 6 unmittelbar, d.h. ohne vorherige Wechselwirkung mit der Probe detektiert und an die Umformeinheit 12a weiterleitet. Das Vergleichssignal 13 wird gemäß diesem Ausführungsbeispiel insofern aus dem Anregungssignal 6 und nicht aus dem Triggersignal 8 abgeleitet.

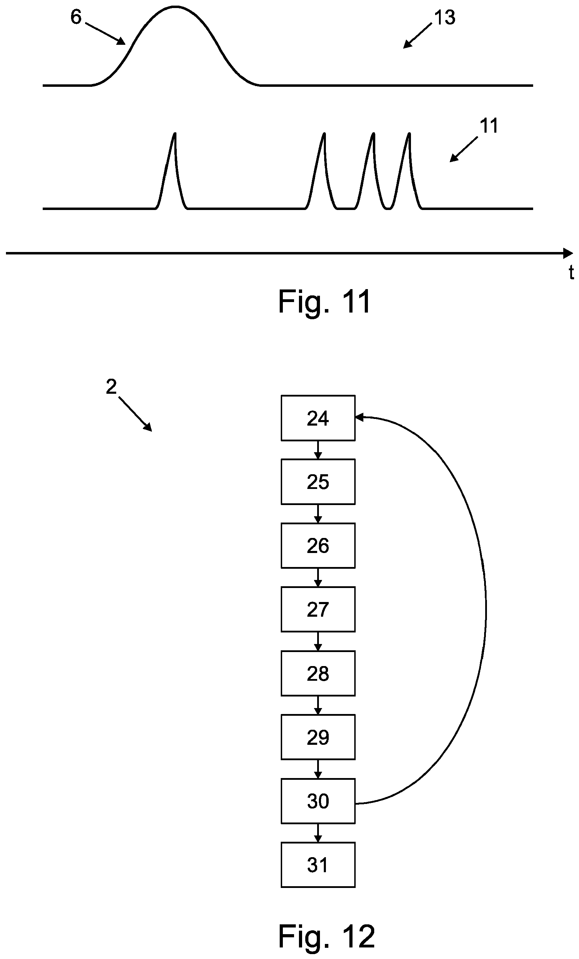

Fig. 11 zeigt den zeitlichen Verlauf des aus dem Anregungssignal 6 abgeleiteten Vergleichssignal 13 und dem Detektorsignal 11. Gemäß dem dargestellten Ausführungsbeispiel ist das Anregungssignal 6 durch die Umformeinheit 12a derart zeitverzögert und geformt, dass das Anregungssignal 6 zeitlich mit dem ersten Anteil 4 des Detektorsignals 11 korreliert.

In Fig. 12 ist ein erstes Ausführungsbeispiel eines erfindungsgemäßen Verfahrens 2 dargestellt, wobei die Messvorrichtung 1 gemäß Fig. 1 ausgestaltet ist. Das erfindungsgemäße Verfahren 2 umfasst in jedem Messzyklus die folgenden Schritte:
- Aussenden 24 eines pulsförmigen Anregungssignals 6 durch die Lichtquelle 5,
- Wechselwirkung des Anregungssignals 6 mit der Probe 10,
- Detektion und Umwandlung 25 des Messsignals 3 in ein Detektorsignal 11 durch den Detektor 9,
- Formen 26 und Verschieben 27 des Triggersignals 8 in der Umformeinheit 12 und Erzeugen des Vergleichssignals 13,
- Verknüpfen 28 des Vergleichssignals 13 und des Detektorsignals 11 in der Logikfunktion 15a zur Separation des ersten Anteils 4 des Messsignals 3 und
- Weiterleitung und Auswertung 29 der Ausgabe der Logikfunktion 15a durch die Auswerteeinheit 14, wobei die Auswertung die Bestimmung der Anzahl an Photonen, die während der Zeitdauer des zu separierenden Anteils des Messsignals 3 auf den Detektor 9 treffen, umfasst.

Dabei passieren die im Ausführungsbeispiel dargestellten Schritte 25 bis 27 im Wesentlichen zeitgleich.

Gemäß dem dargestellten Ausführungsbeispiel durchläuft das Verfahren während einer Messzeit mehrere Messzyklen mit den Schritten 24 bis 30. Während der Messzeit summiert 30 die Auswerteeinheit die pro Messzyklus gemessene Anzahl an Photonen zu einer Gesamtzahl auf. Gemäß dem dargestellten Ausführungsbeispiel umfasst das Verfahren mehrere Messzeiten. Anschließend ermittelt 31 die Auswerteeinheit die Ramanaktivität der Probe basierend auf einer statistischen Auswertung umfassend zum Beispiel eine Mittelwertbildung der während den verschiedenen Messzeiten ermittelten Gesamtanzahlen.

### Bezugszeichen

- 1: Messvorrichtung
- 2: Verfahren
- 3: Messsignal
- 4: erster Anteil des Messsignals
- 5: Lichtquelle
- 6: Anregungssignal
- 7: Trigger
- 8: Triggersignal
- 9: Detektor
- 10: Probe
- 11: Detektorsignal
- 12a-c: Umformeinheit
- 13: erstes Vergleichssignal
- 14: Auswerteeinheit
- 15a,b: Logikfunktion
- 16: Verzögerungselement
- 17: Mittel zur Formung
- 18: Von dem Detektorsignal abhängiges Signal
- 19: TDC
- 20: Mikrocontroller
- 21: zweites Vergleichssignal
- 22: zweiter Anteil des Detektorsignals
- 23: integrierter Schaltkreis
- 24: Aussenden des Anregungssignals
- 25: Detektion und Umwandlung des Messsignals
- 26: Formen des Anregungssignals oder des Triggersignals
- 27: Verschieben des Anregungssignals oder des Triggersignals
- 28: Verknüpfen des Vergleichssignals und einem von dem Detektorsignal abhängigen Signal
- 29: Weiterleitung und Auswertung
- 30: Aufsummieren
- 31: Statistische Analyse

## Patentansprüche

1. Messvorrichtung (1) zur zeitaufgelösten Messung eines Messsignals (3) und zur zeitlichen Separation wenigstens eines ersten Anteils (4) des Messsignals (3), mit einer Lichtquelle (5) zur Aussendung eines pulsförmigen Anregungssignals (6), mit wenigstens einem Detektor (9) für den Empfang des Messsignals (3), wobei der Detektor (9) aus dem Messsignal (3) ein Detektorsignal (11) erzeugt, mit wenigstens einer ersten Umformeinheit (12a) zur Erzeugung eines ersten Vergleichssignals (13), und mit wenigstens einer Auswerteeinheit (14),
**dadurch gekennzeichnet,**
**dass** das erste Vergleichssignal (13) mit dem Anregungssignal (6) korreliert, dass wenigstens eine erste Logikfunktion (15a) vorhanden ist, wobei die erste Logikfunktion (15a) im Betrieb zumindest das erste Vergleichssignal (13) und ein von dem Detektorsignal (11) abhängiges Signal (11, 18) derart miteinander verknüpft, dass die Ausgabe der Logikfunktion (15a) ein Maß für die Intensität des ersten Anteils (4) des Messsignals (3) bzw. des Detektorsignals (11) bereitstellt, wobei die Intensität eines Anteils des Messsignals durch die Anzahl an Photonen, die während der Zeitdauer des zu separierenden Anteils des Messsignals auf den Detektor treffen, gegeben ist und
**dass** der Ausgang der ersten Logikfunktion (15a) mit der wenigstens einen Auswerteeinheit (14) verbunden ist.

2. Messvorrichtung (1) nach Anspruch 1, **dadurch gekennzeichnet, dass** die Korrelation zwischen dem ersten Vergleichssignal (13) und dem Anregungssignal (6) darin besteht, dass das erste Vergleichssignal (13) aus dem Anregungssignal (6) abgeleitet ist.

3. Messvorrichtung (1) nach Anspruch 1 oder 2, **dadurch gekennzeichnet, dass** die Lichtquelle (5) einen Trigger (7) aufweist, wobei der Trigger (7) mittels eines Triggersignals (8) das pulsförmige Anregungssignal (6) auslöst und wobei die Korrelation zwischen dem ersten Vergleichssignal (13) und dem Anregungssignal (6) darin besteht, dass das erste Vergleichssignal (13) aus dem Triggersignal (8) abgeleitet ist.

4. Messvorrichtung (1) nach einem der Ansprüche 1 bis 3, **dadurch gekennzeichnet, dass** die Umformeinheit (12a) wenigstens eine Verzögerungseinheit (16) aufweist, wobei die Verzögerungseinheit (16) derart ausgestaltet ist, dass im Betrieb das pulsförmige Anregungssignal (6) oder das Triggersignal (8) durch die Verzögerungseinheit (16) zeitlich mit dem von dem Detektorsignal abhängigen Signal (11, 18) synchronisiert ist.

5. Messvorrichtung (1) nach einem der Ansprüche 1 bis 4, **dadurch gekennzeichnet, dass** die Umformeinheit (12a) wenigstens ein Mittel (17) zur Erzeugung wenigstens eines positiven Signals für eine Zeitdauer t₂ in einem zeitlichen Abstand von t₁ ≥ 0 von dem Anregungssignal (6) oder dem Triggersignal (8) aufweist.

6. Messvorrichtung (1) nach einem der Ansprüche 1 bis 5, **dadurch gekennzeichnet, dass** die Umformeinheit (12a) wenigstens ein Mittel zur zeitlichen Dehnung und/oder zur zeitlichen Stauchung des Anregungssignals (6) oder des Triggersignals (8) aufweist.

7. Messvorrichtung (1) nach einem der Ansprüche 1 bis 6, **dadurch gekennzeichnet, dass** wenigstens eine weitere Umformeinheit (12b) mit dem Ausgang des Detektors (9) verbunden ist, wobei die weitere Umformeinheit (12b) vorzugsweise eine Verzögerungseinheit (16) aufweist, wobei die Verzögerungseinheit (16) vorzugsweise den ersten Anteil (4) des Detektorsignals (11) mit dem Anregungssignal (6) oder dem Triggersignal (8) zeitlich synchronisiert.

8. Messvorrichtung (1) nach einem der Ansprüche 1 bis 7, **dadurch gekennzeichnet, dass** die Logikfunktion (15a, 15b) wenigstens eine AND-Verknüpfung, eine OR-Verknüpfung, eine XOR-Verknüpfung, eine NAND-Verknüpfung, eine NOR-Verknüpfung oder eine XNOR-Verknüpfung umfasst.

9. Messvorrichtung (1) nach einem der Ansprüche 1 bis 8, **dadurch gekennzeichnet, dass** zur Bestimmung des Zeitversatzes, insbesondere zwischen dem Anregungssignal (6) bzw. dem Triggersignal (8) und dem ersten Anteil (4) des Detektorsignals (11), ein Time-to-Digital-Converter (TDC) (19) vorhanden ist.

10. Messvorrichtung (1) nach einem der Ansprüche 1 bis 9, **dadurch gekennzeichnet, dass** die wenigstens eine Logikfunktion (15a, 15b) und/oder die wenigstens eine Umformeinheit (12a, 12b, 12c) in einem Mikrocontroller (20) implementiert sind.

11. Messvorrichtung (1) nach einem der Ansprüche 1 bis 10, **dadurch gekennzeichnet, dass** die wenigstens eine Logikfunktion (15a, 15b) als Logikgatter ausgestaltet ist.

12. Messvorrichtung (1) nach einem der Ansprüche 1 bis 11, **dadurch gekennzeichnet, dass** die Auswerteeinheit (14) wenigstens einen Zähler umfasst.

13. Messvorrichtung (1) nach einem der Ansprüche 1 bis 12, **dadurch gekennzeichnet, dass** wenigstens eine weitere Umformeinheit (12c) zur Erzeugung eines zweiten Vergleichssignals (21) vorhanden ist, wobei das zweite Vergleichssignal (21) mit dem Anregungssignal (6) korreliert, wobei wenigstens eine zweite Logikfunktion (15b) vorhanden ist, wobei die zweite Logikfunktion (15b) das zweite Vergleichssignal (21) und ein von dem Detektorsignal abhängiges Signal (11, 18) derart miteinander verknüpft, dass die Ausgabe der Logikfunktion (15b) ein Maß für die Intensität eines zweiten Anteils (22) des Messsignals (3) bereitstellt und dass der Ausgang der zweiten Logikfunktion (15b) mit der wenigstens Auswerteeinheit (14) verbunden ist.

14. Verfahren (2) zur zeitaufgelösten Messung eines Messsignals (3) und zur zeitlichen Separation wenigstens eines ersten Anteils (4) des Messsignals (3), mit einer Messvorrichtung (1), wobei die Messvorrichtung (1) eine Lichtquelle (5) zur Aussendung eines pulsförmigen Anregungssignals (6) aufweist, wobei die Messvorrichtung (1) wenigstens einen Detektor (9) für den Empfang des Messsignals (3) aufweist, wobei der Detektor (9) aus dem Messsignal (3) ein Detektorsignal (11) erzeugt, wobei die Messvorrichtung (1) wenigstens eine Umformeinheit (12a) zur Erzeugung eines ersten Vergleichssignals (13) aufweist, und wobei die Messvorrichtung (1) wenigstens eine Auswerteeinheit (14) aufweist,
**dadurch gekennzeichnet,**
**dass** das erste Vergleichssignal (13) mit dem Anregungssignal (6) korreliert, dass wenigstens eine erste Logikfunktion (15a) vorhanden ist, wobei die erste Logikfunktion (15a) das erste Vergleichssignal (13) und ein von dem Detektorsignal abhängiges Signal (11, 18) miteinander verknüpft und dass der Ausgang der ersten Logikfunktion (15a) mit der wenigstens einen Auswerteeinheit (14) verbunden ist, wobei das Verfahren (2) in einem Messzyklus die folgenden Schritte aufweist:
- Aussenden (24) eines pulsförmigen Anregungssignals (6) durch die Lichtquelle (5),
- Wechselwirkung des Anregungssignals (6) mit der Probe (10),
- Detektion und Umwandlung (25) des Messsignals (3) in ein Detektorsignal (11) durch den Detektor (9),
- Erzeugen des Vergleichssignals (13) in der Umformeinheit (12a),
- Verknüpfen (28) des Vergleichssignals (13) mit einem von dem Detektorsignal (11) abhängigen Signal (11, 18) in der Logikfunktion (15a) zur Separation des ersten Anteils (4) des Messsignals (3) und
- Weiterleitung und Auswertung (29) der Ausgabe der Logikfunktion (15a) durch die Auswerteeinheit (14), wobei die Auswertung die Bestimmung der Anzahl an Photonen, die während der Zeitdauer des zu separierenden Anteils des Messsignals auf den Detektor treffen, umfasst.

15. Verfahren nach Anspruch 14, **dadurch gekennzeichnet, dass** das Verfahren eine Messvorrichtung (1) gemäß einem der Ansprüche 1 bis 13 umfasst.
